# EUROPÄISCHE PATENTSCHRIFT

(11) **EP 0 285 745 B1**
(45) Veröffentlichungstag und Bekanntmachung des Hinweises auf die Patenterteilung: **26.05.1993**
(21) Anmeldenummer: 88100362.8
(22) Anmeldetag: 13.01.1988
(51) Int. Cl.: C23C 14/32

(54) **Verfahren und Vorrichtungen zum Vakuumbeschichten mittels einer elektrischen Bogenentladung**
Process and apparatus for vacuum coating by means of an electric arc discharge
Procédé et dispositifs de déposition sous vide utilisant une décharge électrique

(30) Priorität: 06.03.1987 CH 841/87
(43) Veröffentlichungstag der Anmeldung: 12.10.1988
(73) Patentinhaber: BALZERS AKTIENGESELLSCHAFT, 9496 Balzers (LI)
(72) Erfinder: Buhl, Rainer, Dr., CH-7320 Sargans (LI); Peyer, Christof, FL-9494 Schaan (LI)
(74) Vertreter: Troesch, Jacques J., Dr. sc. nat.

(56) Entgegenhaltungen:
- EP-A- 0 106 638
- EP-A- 0 275 018
- WO-A-85/03954
- US-A- 4 600 489
- ARC PLASMA PHYSICAL VAPOR DEPOSITION, Clark Bergmann, 28th Tech. Conf. Soc. Vacuum Coates, 29 April-03 May 1985, Philadelphia, PA (US)#

## Beschreibung

Mit der Anwendung plasmaunterstützter Vakuumbeschichtungsverfahren wurde die Palette der Verbindungen, welche reaktiv durch Zufuhr der nötigen Komponenten aus verschiedenen Quellen bei der Abscheidung auf einem Substrat erzeugt werden können, über die verbreitete Herstellung von Oxiden hinaus bedeutend erweitert. Meist wird eine benötigte metallische Komponente durch Verdampfen oder durch Zerstäuben dem Beschichtungsraum zugeführt, während die zweite oder weitere Komponenten gasförmig eingelassen werden.

Metallverdampfung mittels Kathodenpunkten einer Bogenentladung eignet sich gut zum plasmaunterstützten Beschichten, denn die Kathodenpunkte emittieren dabei das Kathodenmaterial im wesentlichen nicht als neutralen Dampf, wie andere für die Vakuumbeschichtung benutzte Quellen, sondern zum überwiegenden Teil bereits als Ionen. Diese bilden zusammen mit den ebenfalls emittierten Elektronen ein Plasma hoher Ladungsträgerdichte, welches eine Beschichtung mit hoher Geschwindigkeit erlaubt. Gleichzeitig sind durch die plasmaunterstützte Schichtbildung günstige Schichteigenschaften (hohe Dichte, gute Festigkeit, geringe Rauhigheit) erreichbar und zwar sowohl für Schichten, die durch Niederschlag des aus der Kathode erzeugten Metalldampfes allein gewonnen werden, wie auch insbesondere für Schichten aus Verbindungen dieses Dampfes mit zugefügten "reaktiven" Gasen, so dass auf den Substraten eine Schicht aus der entsprechenden Verbindung entsteht.

Bei einer ebenen Kathode gehorcht die Richtungsverteilung der emittierten Ionen nahezu dem cos-Gesetz, d.h.,die in einer Richtung, welche mit dem Lot auf die Kathodenfläche den Winkel α einschliesst, beobachtete Strömung des verdampften Materials ist um den Faktor cos α kleiner als die Emission in der Senkrechten. Diese Intensitätsverteilung liegt auch bei der Emission anderer für die Vakuumbeschichtung bekannter Dampfquellen angenähert vor. Es ist deshalb vom Gesichtspunkt einer rationellen Beschichtung her gesehen zweckmässig, die zu beschichtenden Substrate nahe dem der verdampfenden Fläche der Quelle zugeordneten Lot anzuordnen.

Bei der Verdampfung mittels Kathodenpunkten empfiehlt sich dies noch aus einem anderen Grund. Im Gegensatz zu anderen Quellen wird nämlich von sogenannten Kathodenpunkten Material von der Oberfläche der Kathode in erheblichem Masse in der Form von kleinen flüssigen Tröpfchen in einer von den Ionen abweichenden Richtungsverteilung emittiert, welche im Fluge oder beim Auftreffen auf die Substrate erstarren, und so verschiedene nachteilige Eigenschaften der Schicht verursachen, wie z.B. erhöhte Rauhigkeit der Schichtoberfläche, Verunreinigung von Schichten, die als chemische Verbindung mit Metalldampf gebildet werden sollen, erhöhte Korrosionsanfälligkeit nach einem Ausbrechen der Spritzer u.a. Am wenigsten Spritzer findet man auf Substraten, die in der Nähe des Lotes angeordnet sind, also dort, wo gleichzeitig die Beschichtungsgeschwindigkeit maximal ist.

Bisher übliche Vorrichtungen für die Vakuumbeschichtung unter Anwendung des Verdampfens durch Kathodenpunkte versuchen diese unterschiedliche Emissionscharakteristik von Dampf und Spritzer auszunutzen, um Schichten mit der kleinstmöglichen Zahl von Fehlern durch Spritzer zu erhalten. Die Substrate werden zu diesem Zweck nahe beieinander in einem relativ zum Durchmesser der Kathoden kleinen Bereich oder in grossem Abstand von den Kathoden so angeordnet, dass die auf den Kathodenflächen errichteten Mittellote auf die Mitte der einzelnen Substrate hin ausgerichtet sind. Doch der in dieser Regel geforderte grosse Abstand der Kathoden von den Substraten einerseits und die kleine Anzahl der nahe den Loten Platz findenden Substrate andererseits erlaubt keine wirtschaftliche, spritzerarme Beschichtung.

Deshalb sind bisher bei der Anwendung der sogenannten Funkenverdampfer zwecks wirtschaftlicher Fertigung Kompromisse in Richtung zu kleinerem Abstand bzw. zu ausgedehnteren Substratfeldern in Kauf genommen worden, was jedoch eine wesentliche Verschlechterung bezüglich der Spritzer zur Folge hat. Daher zielen bereits verschiedene bekannte Bestrebungen auf eine Verminderung der Spritzer, die ohne Beeinträchtigung der Wirtschaftlichkeit erreicht werden sollte. Es ist bekannt, dass die Zahl der Spritzer vermindert werden kann, wenn die Verweilzeit des Kathodenpunktes an der jeweiligen Stelle der Kathode nur kurz ist. Doch das zu diesem Zweck vorgeschlagene Abschalten des Stromes und Wiederzünden nach kurzen Pausen ist mit einer Beschichtung in kommerziellem Masstab nicht verträglich.

Bekanntlich richtet sich die Anzahl der gleichzeitig aktiven Kathodenpunkte nach dem für die Kathodenzerstäubungsentladung zur Verfügung stehenden Strom, wobei ein Kathodenpunkt je nach Kathodenmaterial einen Strom zwischen 50 und 150 A emittiert. Die Kathodenpunkte bewegen sich statistisch über die Oberfläche der Kathode hin und her. Sie können durch geeignete Magnetfelder auf Bewegungen in einem erwünschten Bereich eingeschränkt werden. Durch ein parallel zur Oberfläche der Kathode gerichtetes starkes Magnetfeld, das jedoch in der Ebene ständig seine Richtung ändern müsste, könnte auch eine kurze Verweilzeit der Kathodenpunkte erreicht werden. Ein solches Verfahren wäre aber umständlich und konnte sich in der industriellen Praxis nicht durchsetzen.

Aus dem Artikel von Clark Bergman "Arc Plasma Physical Vapor Deposition", Annual Technical Conference Society, April 29 - May 3, 1985, Philadelphia, ist es bekannt, in einer Vakuumkammer zentrisch vorgesehene Substrate von drei Seiten her mittels elektrischer Bogenentladung zu beschichten. Durch die gegenseitige Lage der Bogenentladungskathoden erfolgt eine gegenseitige Beschichtung der Kathoden in Randbereichen, während vorgesehene Substrate bzw. deren Halter einen Grossteil der Kathodenflächen gegenseitig abdecken. Das beschriebene Verfahren ist ein reaktives Verfahren, und es ist mit Bezug auf die Bogenentladungsbeschichtung die Erscheinung der Kathodenvergiftung beschrieben, welche bei einem bestimmten Reaktivgas Massefluss sprungartig zunimmt, worauf die Verdampfungsrate abnimmt.

Die vorliegende Erfindung setzt sich, ausgehend von einem Verfahren bzw. einer Vorrichtung letztgenannter und im Oberbegriff von Anspruch 1 bzw. der in Anspruch 12 spezifizierten Art, die Aufgabe, ein Verfahren bzw. die Verwendung einer Vorrichtung vorzuschlagen, womit ein spritzerarmes Beschichten von Substraten mit grösserer Wirtschaftlichkeit als bisher möglich wird. Diese Aufgabe wird durch das Verfahren gemäß Anspruch 1 bzw. durch die Verwendung einer Vorrichtung gemäß Anspruch 12 gelöst.

Der Erfindung liegt die Beobachtung zugrunde, dass nach dem Zünden der Entladung während einer gewissen Zeitspanne zwar die für die Bildung einer kompakten Schicht benötigten Zonen emittiert werden, jedoch fast keine Spritzer. In dieser Zeitspanne wird anscheinend eine z.B. vom vorhergehenden Fluten herrührende Kontaminationsschicht von der Kathodenoberfläche abgetragen. Es ist auch gemessen worden, dass die mittlere Bewegungsgeschwindigkeit der Kathodenpunkte während dieser Zeitspanne erheblich erhöht ist. Damit wird offenbar auch die mittlere Verweilzeit an jeweils einer bestimmten Stelle der Kathodenfläche verringert und dies hat den günstigen Effekt, die Entstehung von Spritzern zu vermindern.

Die von der Erfindung vorgeschlagene Beschichtung der Kathode mit einer Metallverbindung, z.B. mit reaktiv erzeugtem TiN, leistet dies nicht nur während einer kurzen anfänglichen Zeitspanne, sondern fortwährend. Damit die im Gleichgewicht der mit dem Abtragen der Kathode stattfindende Beschichtung derselben für den Zweck der Erfindung genügt, muss die Beschichtungsrate relativ zur mittleren Abtragrate der Kathode - diese ist proportional zur Stromdichte der Zerstäubungsentladung - über einer vom Material abhängigen Mindestgrösse liegen. Dabei tritt die Wirkung gemäss Erfindung aber nicht abrupt auf sondern stellt sich allmählich mit zunehmendem Verhältnis der Beschichtungsrate zur Abtragrate ein.

Insbeondere für reaktive Beschichtungen, d.h. für die Herstellung von Schichten aus Verbindungen in der Weise, dass die für die Bildung der Verbindung nötigen Komponenten der einen Art durch Verdampfung und die anderen gasförmig dem Reaktionsraum zugeführt werden (wie z.B. bei der Bildung von TiN aus verdampftem Titan und eingelassenem Stickstoff) hat sich das erfindungsgemässe Verfahren als eine sehr wirksame Methode erwiesen. Im Rezipienten können dabei mehrere Kathoden so angeordnet werden, dass sie nicht nur die Substrate, sondern auch sich gegenseitig selbst beschichten. Wenn gleichzeitig die Kathoden für die Verdampfung durch Kathodenpunkte grosse Flächen darstellen, so dass die mittlere Stromdichte nicht zu hoch ist, erzielt man sogar noch in Richtungen, die mehr als 45° zum Lot auf der Kathodenfläche geneigt sind, Schichten, die ärmer an Spritzern sind als Schichten, die bei Verwendung einer einzigen Kathode oder mehrerer Kathoden, welche der erfindungsgemässen Bedingung nicht genügen, in Richtungen von 25° zum Lot erhalten werden. Durch die Erfindung wird also ohne Qualtitätseinbusse eine bedeutende Vergrösserung des für die Anordnung der zu beschichtenden Substrate verfügbaren Raumwinkels erzielt und damit eine ganz wesentliche Erhöhung der Wirtschaftlichkeit erreicht.

Nachfolgend wird die Erfindung anhand anliegender Zeichnungen noch näher erläutert:
Es zeigt
Figur 1 einen Schnitt durch eine für die Durchführung der Erfindung geeignete Vakuumbeschichtungsanlage, welche zwei Kathoden aufweist, die sich gegenseitig beschichten;
Figur 2 einen Schnitt durch eine weitere geeignete Anlage mit nur einer Kathode, jedoch mit einer Hilfseinrichtung zur thermischen Bedampfung dieser Kathode mit einer Metallverbindung;
Figur 3 ein Diagramm betreffend die Häufigkeit der Spritzer verschiedener Grössenklassen auf Schichten, die teils nach dem bekannten Stand der Technik, teils gemäss Erfindung hergestellt worden sind;
Figur 4 einen Schnitt durch eine für die Durchführung der Erfindung ebenfalls bewährte Vakuumbeschichtungsanlage.

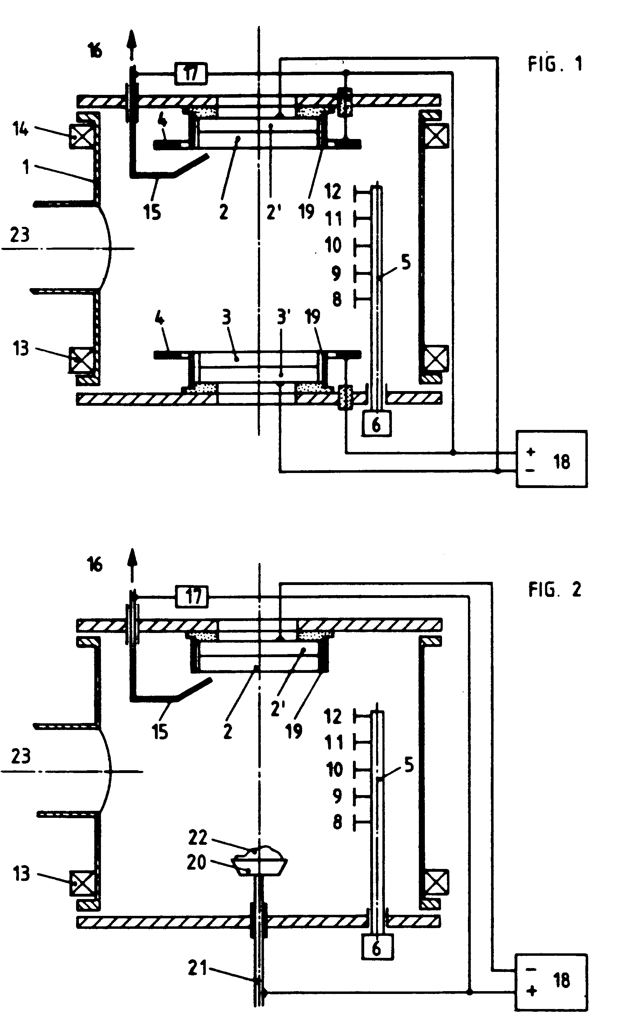

In Figur 1 bedeutet 1 eine zylindrische Vakuumbeschichtungskammer, welche durch die Pumpöffnung 23 evakuiert werden kann. Darin angeordnet sind die Kathoden 2 und 3, die in Form von Scheiben am Deckel und Boden der Anlage mittels Isolatoren elektrisch isoliert befestigt sind. Sie sind je mit einer Kühltasche 2'bzw. 3' ausgestattet,um durch ein zirkulierendes Kühlmittel die anfallende Verlustwärme abführen zu können. Jede der beiden Kathoden ist mit dem negativen Pol der Stromquelle 18 verbunden, deren positiver Pol je an eine der die beiden Kathoden umgebenden ringförmigen (also als Anoden geschalteten) Scheiben 4 geführt ist, welche die Elektronen aus der Gasentladung wieder abführen.

Vorteilhafterweise ist jede Kathode ausserdem mit einem sogenannten Zündfinger 15, (nur derjenige für die obere Kathode ist gezeichnet) ausgerüstet, welcher mittels einer vakuumdicht durch die Kammerwand hindurchgeführten Betätigungsvorrichtung 16 in Pfeilrichtung bewegt werden kann, so dass man die Kathode mit dem Zündfinger berühren oder diesen von ihr entfernen kann. Der dabei fliessende Strom wird durch einen Widerstand 17 auf einige 10 A begrenzt. Der beim Abheben des Zündfingers von der Kathode entstehende Unterbrechungsfunke entwickelt sich dann zum ersten der für die Verdampfung benötigten Kathodenpunkte.

Die beiden Kathoden 2 und 3 sind mit je einem zylinderförmigen, isoliert montiertem Blech 19 umgeben, die ein Abwandern der Kathodenpunkte an die zylindrische Seitenwand der Kathode verhindern und so die Bewegung derselben auf die Stirnfläche der Kathoden beschränken.

Weiter sind Spulen 13 und 14 vorhanden - sie können als Helmholtz-Paar geschaltet sein - welche bewirken, dass schon bei kleiner Feldstärke von etwa 10 Gauss ein Erhöhen der Plasmadichte und ein Erhöhen der gegenseitigen Beschichtungsrate der beiden Kathoden bei konstantem Bogenstrom eintritt.

In der Beschichtungskammer sind ferner Substrathalter 5 drehbar angeordnet, welche mit einem Antrieb 6 verbunden sind, um so durch eine Rotationsbewegung eine gleichmässigere Beschichtung zu erhalten. An den Substrathaltern 5 sind die Einzelhalter 8 bis 12 befestigt.

Die in Figur 2 gezeigte Beschichtungsanlage unterscheidet sich von derjenigen nach Figur 1 dadurch, dass sie nur die obere Kathode 2 in der beschriebenen Art aufweist und anstelle der zweiten Kathode eine Hilfseinrichtung 20 zur Bedampfung der oberen Kathode mit einer Metallverbindung vorgesehen ist. Diese Hilfseinrichtung kann z.B. als ein auf Anodenpotential gelegter Verdampfungstiegel ausgebildet sein, welcher über eine elektrisch isoliert und vakuumdicht durch den Boden der Anlage hindurchgeführte Leitung 21 an die positive Seite der Spannungsquelle 18 gelegt wird. Beim Betrieb wird der Tiegel 20 einem Elektronenbeschuss unterworfen und erhitzt sich dabei, so dass die darin befindliche Substanz 22 verdampft. Entweder wird im Rahmen der Erfindung unmittelbar eine im Tiegel befindliche Metallverbindung verdampft oder ein Metall, das in Anwesenheit eines reaktiven Gases im Beschichtungsraum auf den Substraten eine Schicht aus der gewünschten Metallverbindung bildet. Durch die Höhe der an den Tiegel angelegten positiven Spannung kann die an ihn abgegebene Leistung gesteuert und damit die Verdampfungsrate passend eingestellt werden. Es ist hiebei vorteilhaft, nur die untere Spule 13 mit Strom zu beschicken, so dass ein zur (kleineren) Anode konvergentes Magnetfeld entsteht.

Die nachfolgenden Ausführungsbeispiele wurden mit einer Beschichtungsanlage nach Figur 1 ausgeführt, doch kann hiefür auch eine Anlage gemäss Figur 2 oder eine andere (bekannte) Beschichtungsanlage verwendet werden, wenn die Möglichkeit gegeben ist, ein Kathodenpunkt-Verdampfung und gleichzeitig eine Beschichtung der Kathode mit einer Metallverbindung durchzuführen.

In einem ersten Ausführungsbeispiel wurden zur Beschichtung von Substraten mit Titannitrid in die Anordnung der Figur 1 zwei Kathoden aus Reintitan eingesetzt. Die Substrate waren zuvor auf übliche Weise in Lösungsmitteln unter Verwendung von Ultraschall gereinigt worden.

Nach Erreichen von Hochvakuum wurde in die Anlage Argon eingelassen bis zu einem Druck von 0,1 bis 1 Pascal und an die Substrathalter eine negative Spannung von etwa 1000 V gelegt, wobei die Substrate von Ionen getroffen werden, welche eine weitere Reinigung durch Zerstäuben bewirken. Nach der Reinigung wurde der Argondruck auf einige 10⁻² Pascal abgesenkt, die Entladung unter Ausbildung von Kathodenpunkten auf den beiden Kathoden gezündet und die an die Sustrate gelegte Spannung auf 70 Volt erniedrigt. Gleichzeitig wurde Stickstoff bis zu einem Druck von 10¹ Pascal eingelassen und dieser Druck während der folgenden Beschichtung konstant gehalten. Der Bogenstrom wurde auf zweimal 300 Ampere eingestellt. Nach einer Beschichtungszeit von 8 Minuten betrugen die TiN-Schichtdicken auf den auf den Halterpositionen 8 bis 12 befindlichen Substraten 2,5 - 3,4 - 3,5 - 3,5 - 2,3 Mikrometer.

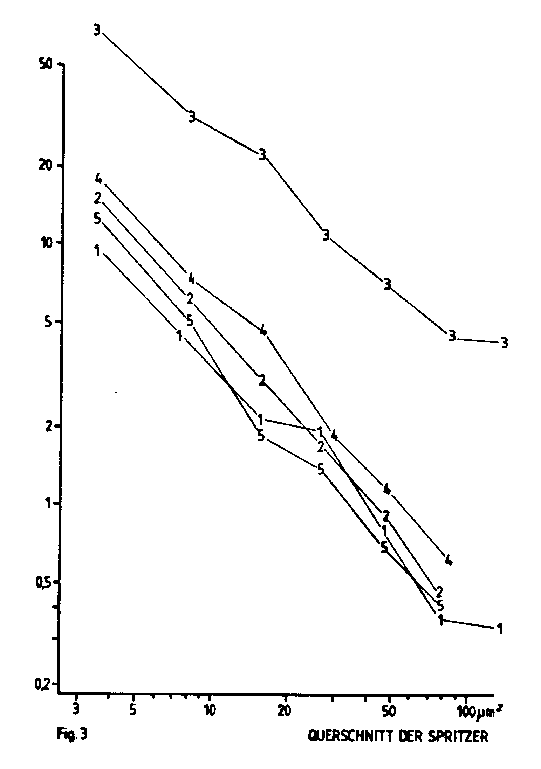

Die Grösse der Spritzer und ihre Häufigkeit wurden sodann auf Mikroaufnahmen, die eine Fläche von 0,025 mm² wiedergaben, ausgemessen und die Ergebnisse in Figur 3 eingetragen. Die mit 1 bezeichnete Kurve stellt die Mittelwerte der Spritzer auf den Schichten der in Position 10 (Fig. 1 und 2) am Substrathalter angebrachten Probescheiben dar; auf der genannten Fläche befanden sich z.B. durchschnittlich etwa 7 Spritzer mit einem Querschnitt von 5 µm², aber nur 2 Spritzer einer Grösse von 2O µm².

In einem zweiten Beispiel für eine Beschichtung mit Titannitrid in derselben Anlage wurde auf dieselbe Weise vorgegangen, nur mit den Unterschied, dass ein höherer Bogenstrom von 2 x 6OO A eingestellt wurde. Wieder wurden Häufigkeit und Grösse an Substraten, die in Position 10 montiert waren, aus Mikroaufnahmen ermittelt und in Figur 3 als Kurve 2 eingetragen.

Um die Erfindung mit dem Stand der Technik zu vergleichen, wurde sodann in der gleichen Beschichtungsanlage (nach Figur 1) auch eine Beschichtung mit Titannitrid, jedoch ohne Benutzung des Verfahrens nach der Erfindung durchgeführt. Die Vorbereitung erfolgte auf dieselbe Weise wie im Beispiel 1, doch wurden zum Beschichten nur Kathodenpunkte auf der unteren Kathode 3 gezündet, die also während des Beschichtungsvorganges nicht ihrerseits durch die ausser Betrieb stehende Kathode 2 beschichtet wurde. Der Strom war auf 600 A eingestellt. Die Beschichtungszeit wurde dementsprechend doppelt so lange gewählt wie bei Beispiel 2. Die damit erhaltene Verteilung der Spritzer auf den wieder in Position 10 montierten Substraten ist als Kurve 3 in Figur 3 ersichtlich. Im Vergleich mit den viel günstigeren Kurven 1 und 2 ersieht man den grossen Vorteil entsprechend der Lehre der Erfindung.

Die in Figur 3 dargestellten Spritzerhäufigkeiten beziehen sich auf mittlere Stromdichten der Emissionsflächen der Kathoden im Bereich 0,7 bis 1,5 A cm⁻². Da von den Kathodenpunkten hauptsächlich Ionen emittiert werden, kann die Beschichtungsrate, die eine dieser Quellen durch die übrigen erfährt, auch durch die Beeinflussung der Bahn der Ionen beispielsweise durch geeignete Magnetfelder unterstützt bez. abgeschwächt werden. In diesem Falle einer Beschichtung mit Ionen ist die Messung zur Einstellung der optimalen Vorbeschichtung besonders einfach durchzuführen. Man legt die eine Kathode, deren Beschichtung ermittelt werden soll, ohne auf ihr einen Funken zu zünden, über einen Strommesser auf das Potential einer der anderen Kathoden. Für die Anwendung einer Beschichtung mit Titannitrid und Titankarbonitrid haben wir so gefunden, dass das Optimum einer spritzerarmen Beschichtung bei einer Rückbeschichtung mit einem Ionenstrom von 1 bis 2 % des später gewählten Entladungsstromes erreicht wird. Da der (elektrische) Strom der emittierten Ionen etwa 8 % des gesamten Bogenstromes ausmacht, ergibt sich in diesem Falle, dass die Rückbeschichtung der Funkenkathode optimal ist, wenn sie zwischen 12 und 25 % des emittierten Ionenstromes ausmacht.

Diese Rückbeschichtung kann, selbstverständlich unter der Voraussetzung, dass die Reaktivität hoch genug ist, so dass die gewünschte Verbindung gebildet wird, wie oben erwähnt, auch mittels einer gewöhnlichen thermischen Bedampfen oder mittels einer Zerstäubungsquelle vorgenommen werden. Die Strommessung kann man durch eine Bestimmung der Masse der pro cm² aufgebrachten Schicht ersetzen, was z.B. mit einem Schwingquarz geschehen kann oder durch Wiegen eines probeweise beschichteten Substrates. (Den entsprechenden Strom einer Ionenbeschichtung erhält man aus der Masse der pro Sekunde auf die betrachtete Kathode aufgebrachten Schicht multipliziert mit der Loschmidt-Zahl 6·10²³, mit der spezifischen elektrischen Ladung eines einfach ionisierten Ions von 1,6 · 10¹⁹ Amperesekunden und mit einem Faktor a etwa gleich 2, welcher den Betrag mehrfach geladener Ionen berücksichtigt und geteilt durch das "Atomgewicht" Masse eines Mols des Schichtmaterials in Gramm).

Ein weiteres Beispiel betrifft die Beschichtung mit Titankarbonitrid. In die in Figur 1 skizzierte Anlage wurden Substrate aus HSS - Stahl eingebracht, und als Reaktionsgas wurde eine Mischung von Stickstoff und eines Kohlenstoff enthaltenden Gases (z.B. Benzol) eingelassen und zwar soviel, dass der Volumengehalt an Kohlenwasserstoff bis zu 50 % betrug. Auch bei dieser Beschichtung war der Vorteil einer Anwendung der Erfindung deutlich, wie die in Figur 3 eingetragene zugehörige Spritzerkurve 4 demonstriert.

Schliesslich sollen noch Beispiele einer Beschichtung mit Titanoxyd bzw. Zirkonnitrid vorgestellt werden.

Für eine Beschichtung mit Titanoxyd wurden in die Anlage (der Fig.1) Kathoden aus Titan eingesetzt und an das Einlassventil für das Reaktionsgas eine Druckflasche mit Sauerstoff angeschlossen. Da Titanoxyde (je nach ihrer chemischen Zusammensetzung) schlechte elektrische Leiter oder sogar gute Isolatoren darstellen, ist es in diesem Falle nicht zielführend, an die Substrate negative Gleichspannung zur Beschleunigung der Ionen auf die Oberfläche der Substrate anzulegen; schon nach kurzer Zeit würde die Substratobefläche durch die entgegengesetzte Ladung, welche von den ankommenden Ionen mitgeführt wird, neutralisiert. Die Erfahrung zeigt aber, dass die kinetische Energie der von den Kathodenpunkten emittierten Titanionen ausreicht, um die für die Bildung der Oxydschichten nötige Aktiviertungsenergie aufzubringen. Damit können nicht nur elektrisch leitfähige Substate, sondern auch Isolatoren mit Oxyden des Titans beschichtet werden.

Auch hiebei wird während der Verdampfung durch die Kathodenpunkte Reaktionsgas, in diesem Falle also Sauerstoff in die Beschichtungskammer eingelassen, wobei nicht nur die Substrate sondern auch die beiden Kathoden mit der für das Schichtmaterial gewünschten Verbindung beschichtet werden. Wie bei Beschichtungen mit Nitrid oder Karbonitrid erhöht das Oxyd die Bewegung der Kathodenpunkte, und es wurden auch hiebei durch Anwendung der Erfindung wesentlich spritzerärmere Beschichtungen (Kurve 5, Fig. 3) auf den Substraten erhalten.

Für die Beschichtung mit Zirkonnitrid wurden in die Beschichtungsanlage zwei scheibenförmige Kathoden aus Zirkon eingebaut. Die Zirkonscheiben mit einer Dicke von 6 mm waren auf Platten aus rostfreiem Stahl aufgelötet. Zur Durchführung der Reinigungs-Zerstäubungsätzung der Substrate wurden diese an eine negative Spannung etwa 300 V gelegt, in den Rezipienten Argon (oder ein anderes Edelgas mit guter Zerstäubungswirkung) bis zu einem Druck von etwa 0,1 Pa eingelassen und die Kathodenpunkte auf beiden Kathoden gezündet. Die Stromdichte auf den Substraten betrug 10⁻² A/cm², womit die Ätzphase nach 10 Minuten beendet und der Beginn der Beschichtungsphase eingeleitet werden konnte. Zuerst wurde nur Kathodenmetall verdampft, nach wenigen Sekunden aber Stickstoff bis zu einem ruck von 10⁻¹ Pa eingelassen, um Zirkonnitrid als Schichtmaterial zu erhalten. Die Substratspannung wurde während der Niederschlagung der Schicht auf etwa - 50 V reduziert.

Auf den Substraten wurde wiederum die Häufigkeitsverteilung der Spritzer ermittelt. Die zugehörige Kurve ist in Figur 3 mit 5 bezeichnet. Wenn eine Vergleichsbeschichtung bei Verwendung nur einer der Zirkonkathoden durchgeführt wird, ergibt sich auch bei ZrN eine Spritzerhäufigkeit, welche mit der mit Ziffer 3 bezeichneten Kurve der Figur 3 nahezu übereinstimmt.

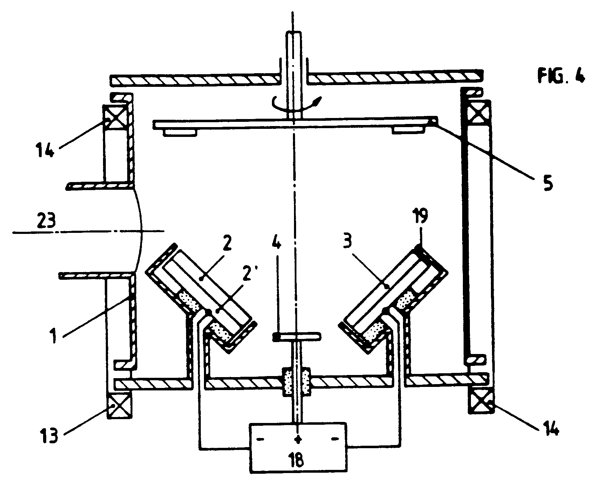

Bekannte Beschichtungsanlagen, die für das Bedampfen unter Anwendung von Kathodenpunkten elektrischer Bogenentladungen als Dampfquellen eingerichtet sind, lassen sich meist ohne weiteres so umbauen, dass mit ihnen auch das erfindungsgemässe Verfahren ausgeübt werden kann. Demgegenüber sind die Anordnungen nach den Figuren 1 und 2 neu. Eine weitere neue Anordnung, die sich bewährt hat, ist in Figur 4 dargestellt. Diese weist in der Beschichtungskammer ebenfalls zwei sich gegenseitig beschichtende Kathoden für die Verdampfung aus Kathodenpunkten auf, die jedoch gegeneinander und gegenüber dem Substrathalter - wie aus Figur 4 ersichtlich - unter bestimmten Winkeln geneigt sind. Das im Sinne der Erfindung geforderte Verhältnis von Beschichtungsrate zur mittleren Abtragrate kann dabei durch den gegenseitigen Abstand der beiden Kathoden und/oder durch passende Einstellung des Magnetfeldes erreicht werden. Auch durch eine Aenderung des Winkels, den die Normalen zu den beiden Kathodenflächen miteinander einschliessen, lässt sich die gegenseitige Beschichtung verändern. (Die hiezu nötige gelenkige Verbindung der Kathoden ebenso wie andere Details der Anlage sind in Figur 4 aber nicht dargestellt).

## Patentansprüche

1. Verfahren zum Vakuumbeschichten mindestens eines Werkstückes mittels elektrischer Bogenentladung zwischen mindestens einer Anode und mindestens einer Kathode, bei dem die Kathode einer Beschichtung ausgesetzt wird und das Kathodenmaterial ein Metall umfasst, dadurch gekennzeichnet, dass die Kathode mit einer Metallverbindung beschichtet wird und die dabei der Kathode zugeführte Metallmenge 12-25% der von der Kathode abgeführten Metallmenge beträgt.

2. Verfahren nach Anspruch 1, dadurch gekennzeichnet, dass die Metallverbindung der Kathodenbeschichtung einen Metallgehalt zwischen 30 und 90 Gew.% aufweist.

3. Verfahren nach einem der Ansprüche 1 oder 2, dadurch gekennzeichnet, dass die Beschichtung der Kathode mit einer Metallverbindung vorgenommen wird, welche das gleiche Metall enthält wie die Kathode.

4. Verfahren nach einem der Ansprüche 1 bis 3, dadurch gekennzeichnet, dass die Beschichtung der Kathode mittels eines reaktiven Prozesses erzeugt wird.

5. Verfahren nach einem der Ansprüche 1 bis 4, dadurch gekennzeichnet, dass als Kathode eine metallische Kathode eingesetzt wird.

6. Verfahren nach einem der Ansprüche 1 bis 5, dadurch gekennzeichnet, dass die Beschichtung der Kathode durch elektrische Bogenentladungsbeschichtung vorgenommen wird.

7. Verfahren nach einem der Ansprüche 1 bis 5, dadurch gekennzeichnet, dass die Beschichtung der Kathode durch Verdampfen einer Substanz in einem Verdampfungstiegel erfolgt.

8. Verfahren nach einem der Ansprüche 1 bis 5, dadurch gekennzeichnet, dass die Beschichtung der Kathode durch Zerstäubung erfolgt.

9. Verfahren nach einem der Ansprüche 1 bis 8, dadurch gekennzeichnet, dass die Beschichtungsrate der Kathode einstellbar ist.

10. Verfahren nach einem der Ansprüche 1 bis 9, dadurch gekennzeichnet, dass mindestens ein zu beschichtendes Werkstück ausserhalb eines Bereiches angeordnet wird, welcher durch Richtungen in 45^{o} zu den Loten auf die Kathodenfläche definiert wird.

11. Verfahren nach Anspruch 6, dadurch gekennzeichnet, dass die Beschichtung des Werkstücks mittels elektrischer Bogenentladung an mindestens zwei Kathoden vorgenommen wird, welche sich gegenseitig beschichten.

12. Verwendung einer weiteren Dampfquelle in einer Vorrichtung zum Vakuumbeschichten mindestens eines Werkstückes, mit einer Vakuumkammer, einem Werkstückträger für das Werkstück, mindestens einer Kathode, deren Material ein Metall umfaßt, und einer Anode, sowie einer elektrischen Speisung zum Unterhalt einer elektrischen Bogenentladung zwischen Anode und Kathode, für die Beschichtung der Kathode mit einer Metallverbindung mit mindestens 12 % der von der Kathode abgeführten Metallmenge.

13. Verwendung nach Anspruch 12, dadurch gekennzeichnet, dass als Dampfquelle ein Verdampfungstiegel (20) vorgesehen ist.

14. Verwendung nach Anspruch 12, dadurch gekennzeichnet, dass als Dampfquelle eine zweite Kathode (3) vorgesehen ist.

15. Verwendung nach Anspruch 14, dadurch gekennzeichnet, dass die gegenseitige Lage der Kathoden einstellbar ist.

16. Verwendung nach Anspruch 12, dadurch gekennzeichnet, dass der Werkstückträger (5) bezüglich der Kathode so angeordnet und ausgebildet ist, dass Trägerbereiche zur Werkstückaufnahme ausserhalb eines Bereiches liegen, welcher definiert ist durch 45^{o} Richtungen bezüglich der Lote auf die Kathodenfläche.

## Claims

1. A process for vacuum coating of at least one workpiece by means of electric arc discharge between at least one anode and at least one cathode, wherein the cathode is exposed to a coating effect and the cathode material includes a metal, characterised in that the cathode is coated with a metal compound and the amount of metal supplied to the cathode in that operation is from 12 to 25% of the amount of metal removed from the cathode.

2. A process according to claim 1 characterised in that the metal compound of the cathode coating has a metal content of between 30 and 90% by weight.

3. A process according to one of claims 1 and 2 characterised in that the operation of coating the cathode is effected with a metal compound which contains the same metal as the cathode.

4. A process according to one of claims 1 to 3 characterised in that the coating on the cathode is produced by means of a reactive procedure.

5. A process according to one of claims 1 to 4 characterised in that a metallic cathode is used as the cathode.

6. A process according to one of claims 1 to 5 characterised in that the operation of coating the cathode is effected by electric arc discharge coating.

7. A process according to one of claims 1 to 5 characterised in that the operation of coating the cathode is effected by vaporisation of a substance in a vaporisation crucible.

8. A process according to one of claims 1 to 5 characterised in that the operation of coating the cathode is effected by sputtering.

9. A process according to one of claims 1 to 8 characterised in that the cathode coating rate is adjustable.

10. A process according to one of claims 1 to 9 characterised in that at least one workpiece to be coated is arranged outside a region which is defined by directions at 45° to the lines perpendicular to the cathode surface.

11. A process according to claim 6 characterised in that the operation of coating the workpiece is effected by means of electric arc discharge at at least two cathodes which coat each other.

12. Use of a further vapour source in an apparatus for vacuum coating of at least one workpiece, comprising a vacuum chamber, a workpiece carrier for the workpiece, at least one cathode whose material includes a metal, and an anode, as well as an electric feed for maintaining an electric arc discharge between anode and cathode, for coating the cathode with a metal compound with at least 12% of the amount of metal removed from the cathode.

13. Use according to claim 12 characterised in that a vaporisation crucible (20) is provided as the vapour source.

14. Use according to claim 12 characterised in that a second cathode (3) is provided as the vapour source.

15. Use according to claim 14 characterised in that the mutual positioning of the cathodes is adjustable.

16. Use according to claim 12 characterised in that the workpiece carrier (5) is of such an arrangement and configuration relative to the cathode that carrier regions for receiving a workpiece lie outside a region which is defined by 45° directions relative to the lines perpendicular to the cathode surface.

## Revendications

1. Procédé pour le revêtement sous vide d'au moins une pièce au moyen d'une décharge en arc électrique entre au moins une anode et au moins une cathode, procédé suivant lequel la cathode est exposée à un revêtement et le matériau de cathode comprend un métal, caractérisé par le fait que la cathode est revêtue par un composé métallique et que la quantité de métal amenée à cette occasion à la cathode s'élève à 12-25% de la quantité de métal enlevée de la cathode.

2. Procédé selon la revendication 1, caractérisé par le fait que le composé métallique du revêtement de la cathode présente une teneur en métal comprise entre 30 et 90% en poids.

3. Procédé selon l'une des revendications 1 ou 2, caractérisé par le fait que le revêtement de la cathode est effectué avec un composé métallique qui contient le même métal que la cathode.

4. Procédé selon l'une des revendications 1 à 3, caractérisé par le fait que le revêtement de la cathode est obtenu au moyen d'un procédé réactif.

5. Procédé selon l'une des revendications 1 à 4, caractérisé par le fait que, comme cathode, on utilise une cathode métallique.

6. Procédé selon l'une des revendications 1 à 5, caractérisé par le fait que le revêtement de la cathode est effectué par un revêtement par décharge en arc électrique.

7. Procédé selon l'une des revendications 1 à 5, caractérisé par le fait que le revêtement de la cathode a lieu par évaporation d'une substance dans un creuset d'évaporation.

8. Procédé selon l'une des revendications 1 à 5, caractérisé par le fait que le revêtement de la cathode a lieu par atomisation.

9. Procédé selon l'une des revendications 1 à 8, caractérisé par le fait que le taux de revêtement de la cathode est réglable.

10. Procédé selon l'une des revendications 1 à 9, caractérisé par le fait qu'au moins une pièce devant être revêtue est disposée en dehors d'une zone qui est définie par des directions à 45° par rapport aux perpendiculaires à la surface de la cathode.

11. Procédé selon la revendication 6, caractérisé par le fait que le revêtement de la pièce est effectué au moyen d'une décharge en arc électrique sur au moins deux cathodes qui se revêtent mutuellement.

12. Utilisation d'une autre source de vapeur dans un dispositif pour le revêtement sous vide d'au moins une pièce, le dispositif comportant une chambre à vide, un support de pièces pour la pièce, au moins une cathode dont le matériau comprend un métal, et une anode, ainsi qu'une alimentation électrique pour entretenir une décharge en arc électrique entre l'anode et la cathode, pour le revêtement de la cathode par un composé métallique présentant au moins 12% de la quantité de métal enlevée de la cathode.

13. Utilisation selon la revendication 12, caractérisée par le fait que, comme source de vapeur, est prévu un creuset d'évaporation (20).

14. Utilisation selon la revendication 12, caractérisée par le fait que, comme source de vapeur, est prévue une deuxième cathode (3).

15. Utilisation selon la revendication 14, caractérisée par le fait que la position réciproque des cathodes est réglable.

16. Utilisation selon la revendication 12, caractérisée par le fait que le support de pièces (5) est disposé par rapport à la cathode et réalisé de telle sorte que des zones de support pour la réception des pièces se situent à l'extérieur d'une zone qui est définie par des directions à 45° par rapport à la perpendiculaire à la surface de la cathode.
